# EUROPEAN PATENT APPLICATION

(11) **EP 4 503 337 A2**
(43) Date of publication of application: **05.02.2025**
(21) Application number: 24191664.2
(22) Date of filing: 30.07.2024
(51) Int. Cl.: H01R 4/02, H01R 12/57, H05K 3/34, H01R 43/02

(54) **A CONNECTOR FOR AN ELECTRONIC COMPONENT**

(30) Priority: 01.08.2023 IN 202341051782
(71) Applicant: Valeo eAutomotive Germany GmbH, 91056 Erlangen (DE)
(72) Inventor: ANBAZHAGAN, Arunprasad, 600130 CHENNAI (IN)
(74) Representative: Valeo Powertrain Systems

(57) **Abstract**

The present subject matter relates to a connector (100) that includes a main body (102) and at least two mounting legs (112). The main body (102), formed with a substantially rectangular profile, includes a front face (104), a bottom face (106) parallel to the front face (104), and a lateral face (108) there-between. The main body (102) further includes a plurality of passages adapted to receive terminals (166) of an electronic component (144). The at least two mounting legs (112) project perpendicularly from the front face (104) of the main body (102). Each of the at least two mounting legs (112) include a detent shoulder extending outwardly. The detent shoulder defines a contact surface that is directed towards the front face (104) of the main body (102).

## Description

### FIELD OF INVENTION

The present subject matter relates to a connector for an electronic component, more particularly, a connector for releasable mounting an electronic component to a substrate. The description herein pertains largely on such a connector for use in automotive applications.

### BACKGROUND

A variety of techniques to connect electronic components to a substrate, such as a PCB, is known. In a known manner, pins (or terminals) from the electronic components are passed through holes preformed in the substrate. The pins are then bent and fixed to the substrate, for instance, by means of soldering. At the time of mounting the electronic component in the above mentioned manner, the electronic component is held by a holding tool so that the pins may be soldered. If not held reliably, there is possibility of slippage of the pins during soldering.

In another known technique, a positioning aid is used for positioning and holding the electronic components such that it can clamp the electronic component to the substrate. Such a positioning aid is disclosed in the prior art document CN1 14172387A. The aforementioned prior art speaks of a positioning aid, made of plastic, to a half-bridge module on a heat sink. The positioning aid of CN114172387A is non removable because it is permanently fixed to the heat sink. Such configurations are not easily serviceable if the need arises. Moreover, such configurations require that the pins be positioned precisely to penetrate into holes in the circuit board. Such technique is inefficient in terms of manufacturing process. Further, in case of an imprecise positioning, the pins may get damaged.

Therefore, the technical problem to be solved by the present subject matter is how to provide a connector that facilitate an efficient connection of electronic components to a substrate, ensuring mounting of the electronic component to be simple and involves fewer processes, whilst maintaining the structural integrity of the electronic component(s) and the connection.

### SUMMARY OF THE INVENTION

The present subject matter seeks to solve the above-mentioned technical problem in conventional connectors of electronic components. Such connectors may be applied to connect electronic components to a substrate for use in automotive applications. However, it is to be understood that the application is not limited to automotive applications alone.

The present subject matter relates to a connector comprising: a main body having a substantially rectangular profile and comprising: a front face and a bottom face parallel to one another and a lateral face there-between; a plurality of passages adapted to receive terminals of an electronic component; and at least two mounting legs projecting perpendicularly from the front face of the main body, each of said mounting legs comprising a detent shoulder extending outwardly and defining a contact surface directed towards the front face of the main body. Accordingly, upon mounting the connector onto a substrate, such as a PCB, the at least two mounting legs facilitate the connector to a snap fit, or press fit, to said substrate. Further, the mounting of the connector is stabilized by virtue of the contact surface which is adapted to abut a surface of a substrate once said connector is mounted. Moreover, the connector holds the terminals of an electronic component in a robust manner so that the terminals do not require to be bend at the time of connecting terminals to a circuit formed on a substrate.

According to an example of the present subject matter, one or more of the at least two mounting legs comprise one or more leg portions, wherein each of the one or more leg portions comprises one detent shoulder formed at a free end thereof. Such a configuration where a detent shoulder is provided for each of the one or more leg portions facilitate the connector to snap fit to a substrate. Moreover, the contact surface on each detent shoulder is configured to abut a surface of a substrate and stabilize the connector from axial and lateral play. Therefore, the terminals may be connected to an electric circuit integrated to a substrate with ease, without the terminals being held by a dedicated tool. Furthermore, it is to be noted that the detent shoulders may be oriented to face directions in relation to one another so that an effective fixture of the connector to a substrate may be achieved.

According to an aspect of the present subject matter, the detent shoulder is formed in an arcuate shape. Such a shape permits the detent shoulder of each leg portion to pass through a hole in a substrate with ease.

According to an aspect of the present subject matter, the at least one flange extends from the lateral face and defines a second contact surface parallel to the front face and bottom face, and directed to face the contact surface of the detent shoulder. Accordingly, in a configuration where the connector is snap fitted to a substrate, one surface of the substrate abuts the contact surface of the detent shoulders; and the other surface of the substrate abuts the second contact surface of the flange(s). Such a sandwiched configuration of the substrate ensures a robust fixture of the connector to such a substrate.

According to an example of the present subject matter, the connector comprises two mounting legs, one on either side of the plurality of passages at the front face of the main body. In an aspect, one of two mounting legs aforementioned comprises two leg portions, and the other of the two mounting legs comprises one leg portion. Such a configuration ensures that the connector is supported at both ends, more particularly, at both ends of the plurality of passages, thereby ensuring structural stability of the connector upon being mounted. In one example, either of the two aforementioned mounting legs is cylindrically shaped.

According to example, the connector is formed of electrically insulating material. Such a material may be plastic, and therefore, lightweight and cost effective.

According to an example of the present subject matter, the main body comprises a first part and a second part fused together, and wherein the plurality of passages is formed there-between. Such a configuration ensures that the terminals are fixed robustly to the connector.

The present subject matter relates also to an electrical device comprising: a substrate defining a top surface, a bottom surface, and an electric circuit printed in at least the top surface; and a connector, configured in accordance with the foregoing description, mounted on the bottom surface of the substrate, wherein terminals of an electronic component is received through the plurality of passages. Accordingly, electronic components in such an electric device may be mounted to the substrate in a simple and cost effective manner since a dedicated tool to hold the terminals is not required while connecting the terminals to the electric circuit. Moreover, the connector is fixed in a robust manner to restrict axial and lateral play, thereby ensuring structural integrity of the connection between the electronic component to the electric circuit.

According to an example of the present subject matter, the electrical device is an electric power converter configured to convert electric power from alternating current (AC) to direct current (DC) and/or vice-versa.

The present subject matter relates also to a method of assembling the electrical device, the method comprising: placing the terminals of the electronic component against a placement surface of the first part, the placement surface being lateral to the front face and the bottom face; placing the second part on the terminals and sandwiching said terminals between the first part and the second part; fusing the second part into the first part for fixture of the terminals to the connector; and mounting the connector to the bottom surface of the substrate, said step of mounting comprising: inserting the at least two mounting legs into a hole formed on the substrate so that the contact surface of the detent shoulder comes in contact with the top surface of the substrate. Accordingly, the terminals of the electronic component is fixed to the connector in a structurally robust manner; and the connector is mounted to the substrate with fewer methods involved. The assembling the aforementioned components in a production line may therefore be performed in an efficient and cost effective manner.

According to an aspect of the present subject matter, the step of mounting the connector to the bottom surface further comprises the second contact surface coming in contact with the bottom surface of the substrate.

### BRIEF DESCRIPTION OF DRAWINGS

The features, aspects, and advantages of the present invention will be better understood with regard to the following description and accompanying figures. The description refers to the annexed drawings, wherein:
FIG. 1 illustrates an isometric view of a connector for an electronic component, configured in accordance with the present subject matter;
FIG. 2A illustrates the connector excluding the electronic component, configured in accordance with an aspect of the present subject matter;
FIG. 2B illustrates the connector in another perspective view, the connector being configured in accordance with the present subject matter;
FIG. 3A illustrates the connector mounted on a substrate for an electrical device, in accordance with an example of the present subject matter; and
FIG. 3B illustrates a zoomed in view of the connector mounted on the substrate, as depicted in FIG. 3A, in accordance with an aspect of the present subject matter;
FIG. 3C illustrates an electric power converter that includes the connector and the substrate on which said connector is mounted, in accordance with an example of the present subject matter;
FIG. 3D illustrates a sectional view of the electric power converter, in accordance with the present subject matter;
FIG. 3E illustrates zoomed in perspective of the electric power converter shown in FIG.3D, in accordance with the present subject matter;
FIG. 4 illustrates a flowchart depicting a method of assembling the electronic component to the connector, in accordance with an example++ of the present subject matter; and
FIG. 5A through 5D depict the connector at each step of the method illustrated in FIG. 4, in accordance with an aspect of the present subject matter.

The figures are not necessarily to scale, and the size of some parts may be exaggerated to more clearly illustrate the example shown. Moreover, the drawings provide examples and/or examples consistent with the description, however, the description is not limited to the examples and/or examples provide in the drawings.

### DETAILED DESCRIPTION

In the description that follows, reference is made to accompanying drawings, which form part thereof, and in which is shown by way of illustration specific implementations in which the invention maybe practiced. These implementations are described in sufficient detail to enable that skilling in the art to practice the invention, and it is to be understood that the implementations may be combined, or that other implementations may be utilized, and that structural and logical changes may be made without departing from the scope of the present invention. The following detailed description is, therefore, not to be taken in a limiting sense, and the scope of the present invention is defined by the appended claims and their equivalents.

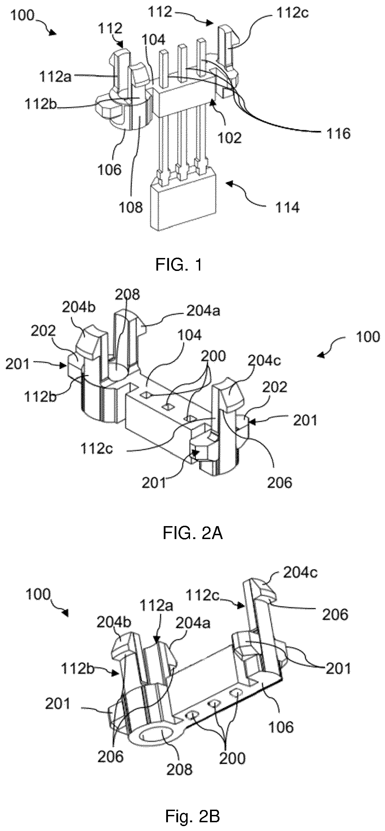

FIG. 1 illustrates a connector 100, configured in accordance with the present subject matter. The connector 100 includes a main body 102 and at least two mounting legs 112. The main body 102 has a substantially rectangular profile and includes a front face 104 and a bottom face 106 parallel to one another. Further, between the aforementioned two flat faces 104, 106, that is, the front face 104 and the bottom face 106, is a lateral face 108 formed there-between. The main body 102 further includes a plurality of passages adapted to receive terminals 116 of an electronic component 114. The at least two mounting legs 112 project perpendicularly from the front face 104. Each of the mounting legs 112 include a detent shoulder extending outwardly. The detent shoulder defines a contact surface that is directed towards the front face 104 of the main body 102.

Accordingly, upon mounting the connector 100 onto a substrate, such as a PCB, the at least two mounting legs 112 facilitate the connector 100 to a snap fit, or press fit, to said substrate. Further, the mounting of the connector 100 is stabilized by virtue of the contact surface, of the detent shoulder, which is adapted to abut a surface of a substrate once said connector 100 is mounted. Moreover, the connector 100, configured in accordance with the present subject matter, holds the terminals 116 of an electronic component 114 in a robust manner so that the terminals 116 do not require to be bend at the time of connecting terminals 116 to a circuit formed on a substrate. The electronic component 114 referred herein may be a resistor or a capacitor or a transistor or a diode or an operational amplifier or a resistor array or a logic gate etc.

According to an example of the present subject matter, one or more of the at least two mounting legs 112 is split into one or more leg portions 112a, 112b, 112c. In such an example, each leg portion 112a, 112b, 112c includes one detent shoulder at a free end thereof. In the example depicted in FIG. 1, one of the at least two mounting legs 112 has a cylindrical outer profile. Accordingly, in a scenario where the connector 100 is to be mounted on a substrate, the detent shoulder(s) is configured to pass through a hole in the substrate to facilitate said mounting.

FIG. 2A illustrates a perspective view of the connector 100, configured in accordance with the present subject matter, in which the electronic component 114 is excluded. FIG. 2B illustrates another perspective view of the connector 100 excluding the electronic component 114. For the sake of brevity, and due to similarity in reference numerals for both the aforementioned figures, the description provided herein pertains to FIG.s 2A and 2B in tandem.

FIG. 2A and 2B depicts the main body 102 and plurality of passages 200 formed there-through. The plurality of passages 200 permit terminals 114 of the electronic component 114 through the main body 102. Preferable, the terminals 114 pass into the plurality of passages 200 from the bottom face 106 and exit from the front face 104. In the example shown, mounting legs 112, formed on the front face 104, is provided on both sides of the plurality of passages 200. In the figures, there are two mounting legs 112, one on either side of the plurality of passages 200.One of these mounting legs 112 is split into two leg portions 112a, 112b, and the other mounting leg 112 includes a single leg portion 112c. The mounting leg 112 with two leg portions 112a, 112b is formed in a substantially cylindrical manner. Each of the two mounting legs 112 may include one or more leg portions 112a, 112b, 112c.

According to the present subject matter, a detent shoulder 204a, 204b, 204c is formed on each of the at least two mounting legs 112. In the examples depicted in figures, the connector 100 includes two mounting legs 112. one of the two mounting legs 112 is split into two leg portions 112a and 112b; and therefore for each of said leg portions 112a and 112b, there is one detent shoulder 204a and 204b respectively. The other mounting leg 112 includes just one leg portion 112c for which the detent shoulder 204c if formed thereof. Each detent shoulder 204a, 204b, 204c defines a contact surface 206. The contact surface 206 on each detent shoulder 204a, 204b, 204c faces the front face 104 of the main body 102. The orientation of the detent shoulders 204a, 204b, 204c is such that the contact surfaces 206 are parallel to the front face 104 of the main body 102. Therefore, upon mounting the connector 100 to a substrate, the orientation of the contact surfaces 206 and the front face 106 is such that said substrate is disposed there-between. In a non-limiting example, the detent shoulders 204a, 204b, 204c are formed in an arcuate shape. Such a shape defines a smooth curved surface on the detent shoulders 204a, 204b, 204c that facilitate easy passing through of said shoulders 204a, 204b, 204c through a hole in a substrate.

According to an example of the present subject matter, the connector 100 includes several leg portions 112. Some leg portions 112 are oriented in an opposite direction to each other. Some mounting leg are perpendicular to each other. In the examples depicted in figures, the leg portions 112a and 112b are oriented in opposite direction to each other. The leg portions 112a and 112c are perpendicular to each other. Similarly, leg portions 112b and 112c are also perpendicular to each other. Such varied orientations of the leg portions 112a, 112b, 112c facilitate enhanced fixation of the connector 100 to a substrate.

According to an example of the present subject matter, the connector 100 further includes at least one flange 201 that extend from the lateral face 108 of the main body 102. The at least one flange 201 defines a second contact surface 202 parallel to the two flat faces, the two flat faces being the front face 104 and the bottom face 106 of the main body 102. The second contact surface 202 is oriented to be parallel to the contact surface 206 of the detent shoulders 204a, 204b, 204c. The connector 100 may include several flanges 201 distant from each other. In the example figures, there are three flanges 201, each having the second contact surface 202 oriented to face the contact surface 206 of the detent shoulder. Notably, for the mounting leg 112 that is split into two leg portions 112a, 112b, there is a dedicated flange 202. For the mounting 112 that has only one leg portion 112c, there are two flanges 202. The flanges 202 are oriented so that the second contact surface 202 is facing the contact surface 206. Accordingly, upon mounting the connector 100 to a substrate, the substrate is sandwiched between the contact surface 206 and the second contact surface 206.

According to an example, the leg portions 112a and 112b that are arranged in opposite directions is separated by a hole 208. Such a configuration with the hole 208 separates the two leg portions 112a, 112b and also provides flexibility for the leg portions 112a and 112b to bend towards each other.

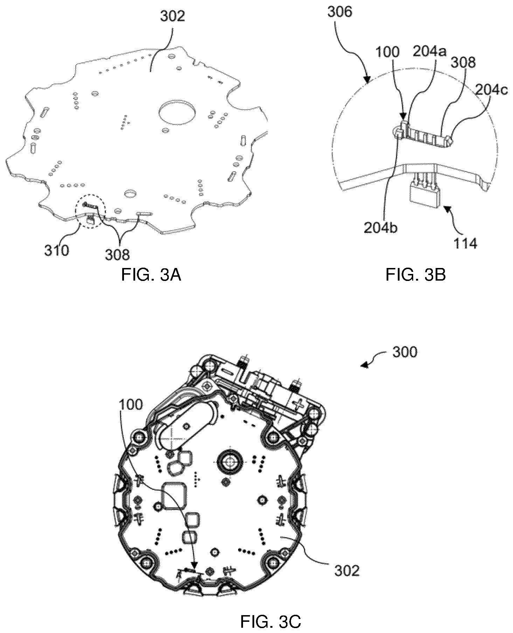

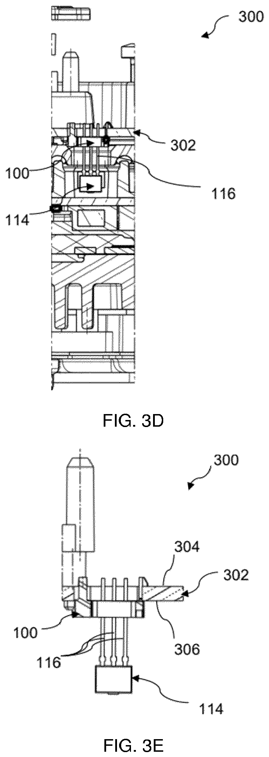

FIG. 3A illustrates the connector 100 mounted on a substrate 302, configured in accordance with an example of the present subject matter. FIG. 3B is a zoomed in view of the connector 100 mounted on the substrate 302, at 310 from FIG. 3A. Figure 3C illustrates an electrical device 300 in which the connector 100 is applied, configured in accordance with an example of the present subject matter. FIG. 3D is a sectional view of the electrical device 300, in accordance with the example shown in FIG. 3C. FIG. 3E is a zoomed in view of the connector 100 mounted on the substrate 302 of the electrical device, in accordance with the example shown in FIG. 3C. For the sake of brevity, the description that follows pertain to FIG.s 3A, 3B, 3C, 3D and 3E in tandem.

According to an example, the connector 100 is mounted on a substrate 302, as shown in FIG. 3A. The detent shoulders 204a, 204b, 204c is passed through a hole 308 in the substrate 302 and exits from another side of the substrate 302. In a non-limiting example, the substrate 302 is a printed circuit board (PCB) where an electric circuit is integrated on at least one side of the PCB. Upon mounting the connector 100 to the substrate 302, the second contact surface 206 abuts a surface of the substrate 302 from which the detent shoulders 204a, 204b, 204c enters through the hole 308. Accordingly, the substrate 302 sits between the contact surface 206 of the detent shoulder 204a, 204b, 204c and the second contact surface 202 formed on the at least one flange 201. Such a configuration ensures a stable mounting of the connector 100 and hence, a reliable electric connection of the terminal 116 may be achieved with the substrate 302. Such an electronic component 114 is any one of a resistor or a capacitor or a transistor or a diode or an operational amplifier or a resistor array or a logic gate etc., configured to electrically connect with the electric circuit integrated to the substrate 302.

Alternatively, the connector 100 may be used as an interconnector (not shown), wherein the plurality of passages 200 are configured to fix interconnecting pins therein. These interconnecting pins may be male or female type pins that facilitate transfer of electric current or signals between two electrical devices, for instance, between an electric power converter and a DC-DC converter. Moreover, such a connector 100, functioning as an interconnector, may be mounted on a PCB within an electrical device, such as, an electric power converter, a DC-DC converter, or a battery pack.

The present subject matter also relates to an electrical device 300 that includes the substrate 302 and the connector 100 as described above. In a non-limiting example, the electric device 300 is an electric power converter for conversion of electric current from alternating current (AC) to direct current (DC) and/or vice-versa. The substrate 302 has a top surface 304, a bottom surface 306, and an electric circuit (not depicted). The electric circuit is printed in at least the top surface 304 of the substrate 302. The connector 100, formed in the manner described above, is mounted from the bottom surface 306 of the substrate 302. Accordingly, terminals 116 of the electronic component 114 is received through the plurality of passages 200 formed in the connector 100. An electric connection between the electronic component 114 and the electric circuit of the substrate 302 may be achieved for an effective conversion of AC to DC and/or vice-versa.

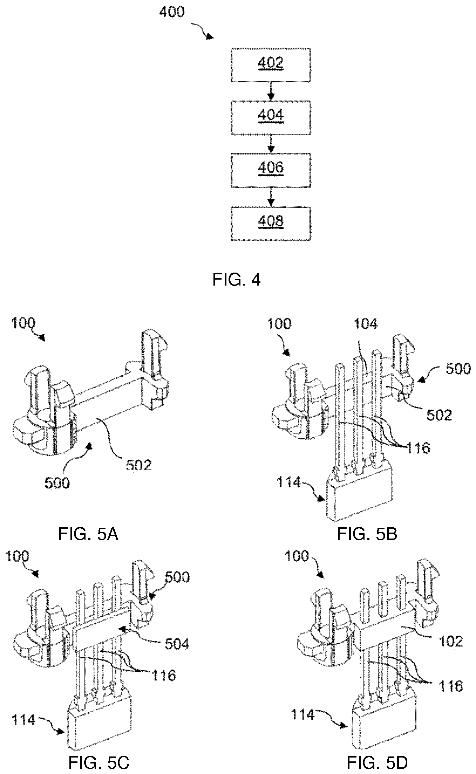

FIG. 4 illustrates a flowchart for a method 400 of assembling the electrical device 300, namely, the connector 100, the electronic component 114, and the substrate 302 together. FIG. 5A, 5B, 5C, and 5D illustrates a step-by-step approach to assembling together the aforementioned components. For the sake of simplicity, the description for FIG. 4 can be read with FIG.s 5A, 5B, 5C and 5D. The description that follows therefore pertain to the aforementioned figures in tandem.

As described in the foregoing description, the connector 100 includes the main body 102. As an example, the main body 102 is preformed and the terminals 116 of the electronic component 114 is passed through the plurality of passages 200. In another example, the main body 102 is formed from two parts fused together with the terminals 116 being placed in between said two parts. FIG. 5A through 5D illustrates one such example where the main body 102 is formed from two parts. FIG. 5A illustrates a first part 500 of the two parts forming the main body 102. A second part 504 of said two parts is shown in FIG. 5C.

According to an aspect of the present subject matter, the method 400 of assembling the terminals 116 of the electronic component 114 includes a step 402 of placing the terminals 116 against a placement surface 502 of the first part 500. The placement surface 502 is oriented perpendicular to the front face 104 and the bottom face 106. Therefore, in an aspect, during the step 402 of placing the terminals 116, the electronic component 114 is first oriented so that the terminals 116 are perpendicular to the front face 104 and the bottom face 106; and then placed against the placement surface 502. The outcome configuration of the aforementioned step 402 of placing the terminals 116 against the placement surface 502 is depicted in FIG. 5B.

The method 400 further includes a step 404 of placing the second part 504 on the terminals 116 so that the terminals 116 are sandwiched between the first part 500 and the second part 504, as depicted in FIG. 5C. The method 400 further includes a step 406 of fusing the second part 504 to the first part 500 of the connector 100. By way of a fusing process, such as, ultrasonic riveting, in the step of 406, the second part 504 is fused to the first part 500 thereby ensuring the terminals 116 are fixed, or assembled, to the connector 100. In a non-limiting way, the connector 100 is formed of electrically insulating material, that is, the first part 500 and the second part 504 are formed from electrically insulating material; and, said parts 500, 504 brought in close proximity together, with the terminals sandwiched there-between, and melted by an application of heat or the like.

According to the present subject matter, the method 400 furthermore includes a step 408 of mounting the connector 100 to the bottom surface 306 of the substrate 302. The aforementioned step 408 of mounting includes inserting the at least two mounting legs 112 into the hole 308 formed on the substrate 302. More particularly, the one or more leg portions 112a, 112b, 112c is inserted through the hole 308. The insertion step in 408 is performed from when the detent shoulders 204a, 204b, 204c enters the substrate 302 from the bottom surface 306 and exits the top surface 304 via the hole 302. Accordingly, the contact surface 206 comes in contact with the top surface 304 of the substrate 302. According to another aspect of the insertion step described above, the step 408 of inserting the leg portions 112a, 112b, 112c is performed till such a time the second contact surface 202 comes in contact with the bottom surface 306 of the substrate 302. The outcome configuration of the aforementioned step 408 of mounting the connector 100 to the substrate 302 is depicted in FIG. 3A and 3B. Such a substrate 302 may be a PCB of an electric power converter such as the one depicted in FIG. 3C, 3D and 3D.

In the example where the electronic component 114 is a capacitor (or any other example electronic component 114 of the like) and the substrate 302 is a PCB, the connector 100, with the electronic component 114 fixed therein, the connector 100 is mounted onto the PCB in step 408. Upon mounting in step 408, the second contact surface 202 of the at least one flange 201 come in contact with the bottom surface 306 of the PCB; and the contact surface(s) 206 of the detent shoulder(s) 204a, 204b, 204c come in contact with the opposite surface, i.e., the top surface 304, from which the detent shoulder(s) 204a, 204b, 204c exit. A stable mounting of the capacitor is achieved accordingly. Any axial and lateral play of the connector 100, and hence, the terminals 116 of the capacitor, is also largely mitigated. A process requiring holding the terminals of the capacitor for soldering is also eliminated.

Various modifications of the disclosed embodiments, as well as alternate embodiments of the subject matter, will become apparent to persons skilled in the art upon reference to the description of the subject matter. It is therefore contemplated that such modifications can be made without departing from the scope of the present subject matter is defined.

## Claims

1. A connector (100) comprising:
a main body (102) having a substantially rectangular profile and comprising:
a front face (104) and a bottom face (106) parallel to one another and a lateral face (108) there-between;
a plurality of passages (200) adapted to receive terminals (116) of an electronic component (114); and
at least two mounting legs (112) projecting perpendicularly from the front face (104) of the main body (102), each of said mounting legs (112) comprising a detent shoulder (204a; 204b; 204c) extending outwardly and defining a contact surface (206) directed towards the front face (104) of the main body (102).

2. The connector (100) as claimed in claim 1 wherein one or more of the at least two mounting legs (112) comprise one or more leg portions (112a; 112b; 112c), wherein each of the one or more leg portions (112a; 112b; 112c) comprises one detent shoulder (204a; 204b; 204c) formed at a free end thereof.

3. The connector (100) as claimed in claim 2, wherein the detent shoulder (204a; 204b; 204c) is formed in an arcuate shape.

4. The connector (100) as claimed in any one of the preceding claims, wherein at least one flange (201) extends from the lateral face (108) and defines a second contact surface (202) parallel to front face (104) and bottom face(106), and directed to face the contact surface (206) of the detent shoulder (204a; 204b; 204c).

5. The connector (100), as claimed in any one of the preceding claims, is formed of electrically insulating material.

6. The connector (100) as claimed in any one of the preceding claims, wherein the main body (102) comprises a first part (500) and a second part (504) fused together, and wherein the plurality of passages (200) is formed there-between.

7. An electrical device (300) comprising:
a substrate (302) defining a top surface (304), a bottom surface (306), and an electric circuit printed in at least the top surface (304); and
a connector (100), as claimed in any one of the preceding claims, mounted on the bottom surface (306) of the substrate (302), wherein
terminals (116) of an electronic component (114) is received through the plurality of passages (200),

8. The electrical device (300) as claimed in claim 6, wherein the electrical device (300) is an electric power converter configured to convert electric power from alternating current (AC) to direct current (DC) and/or vice-versa.

9. A method (400) of assembling the electrical device (300) configured in accordance with the previous claim, the method (400) comprising:
placing the terminals (116) of the electronic component (114) against a placement surface (502) of the first part (500), the placement surface (502) being lateral to the front face (104) and the bottom face (106);
placing the second part (504) on the terminals (116) and sandwiching said terminals (116) between the first part (500) and the second part (504);
fusing the second part (504) into the first part (500) for fixture of the terminals (116) to the connector (100); and
mounting the connector (100) to the bottom surface (306) of the substrate (302), said step of mounting comprising:
inserting the at least two mounting legs (112a; 112b; 112c) into a hole (208) formed on the substrate so that the contact surface (206) of the detent shoulder (204a; 204b; 204c) comes in contact with the top surface (304) of the substrate (302).

10. The method (400) as claimed in the preceding claim, wherein the step of mounting the connector (100) to the bottom surface (306) further comprises the second contact surface (202) coming in contact with the bottom surface (306) of the substrate (302).
